Europäisches Patentamt

European Patent Office

Office européen des brevets

(19)

(11) Publication number: 0 340 981
A2

(12) EUROPEAN PATENT APPLICATION

(21) Application number: 89304284.6

(51) Int. Cl.4: G11C 17/00

(22) Date of filing: 28.04.89

(30) Priority: 28.04.88 JP 106298/88
20.05.88 JP 123636/88
16.05.88 JP 118984/88

(43) Date of publication of application:
08.11.89 Bulletin 89/45

(84) Designated Contracting States:
AT DE FR GB IT NL

(71) Applicant: SONY CORPORATION
7-35 Kitashinagawa 6-Chome Shinagawa-ku
Tokyo 141(JP)

(72) Inventor: Hirose, Harumi c/o Patents Division
Sony Corporation 6-7-35 Kitashinagawa
Shinagawa-ku
Tokyo 141(JP)
Inventor: Ando, Toshizumi c/o Patents
Division
Sony Corporation 6-7-35 Kitashinagawa
Shinagawa-ku
Tokyo 141(JP)
Inventor: Takekawa, Yoshiki c/o Patents
Division
Sony Corporation 6-7-35 Kitashinagawa
Shinagawa-ku
Tokyo 141(JP)
Inventor: Isogawa, Toshiaki c/o Patents
Division
Sony Corporation 6-7-35 Kitashinagawa
Shinagawa-ku
Tokyo 141(JP)
Inventor: Nakata, Shingo c/o Patents Division
Sony Corporation 6-7-35 Kitashinagawa
Shinagawa-ku
Tokyo 141(JP)

(74) Representative: Thomas, Christopher Hugo et
al
D Young & Co 10 Staple Inn
London WC1V 7RD(GB)

(54) Information storage apparatus and methods.

(57) In a storage device incorporating an electrically erasable read only memory (1) or other data storage device capable of a limited number of total times of re-writing, a pointer is stored corresponding to the capacity of the memory (1), which pointer identifies a start position in the data storage device at which re-writing is to occur, and the pointer is incremented sequentially with each writing of the data storage device (1).

FIG.1

## INFORMATION STORAGE APPARATUS AND METHODS

This invention relates to information storage apparatus and methods.

An electrically erasable programmable read-only memory (EEPROM) is commonly used as a re-writable, non-volatile memory for data back-up during a power OFF period. However, it is disadvantageous that such devices have a limited number of re-writings guaranteed by the manufacture, and so it is sometimes impractical to use than for such data back-up. For example, if 10,000 re-writings are guaranteed, the life time of the memory will be about three years if it is re-written ten times a day.

According to the present invention there is provided apparatus for storing information in a memory device capable of a finite total number of re-writings, the apparatus comprising;
a plurality of data areas in said memory device;
characterized by:
a plurality of pointer areas corresponding to said data areas in said memory device to show the order of using said data areas for reading and writing; and
a control means for identifying the start position to re-write, and to change the contents of said pointer areas sequentially in accordance with writing data to said data areas.

According to the present invention there is also provided electronic apparatus comprising:
a system for performing various functions of said electronic apparatus;
characterized by:
storage means for storing information concerning said apparatus in a memory device capable of a finite total number of re-writings, and further comprising:
a plurality of data areas in said memory device;
a plurality of pointer areas corresponding to said data areas in said memory device to show the order of using said data areas for reading and writing; and
a control means for identifying the start position to re-write, and to change the contents of said pointer areas sequentially in accordance with writing data to said data areas.

According to the present invention there is also provided a method of storing information written in a memory device having a plurality of data areas and a plurality of pointer areas corresponding to said data areas, said method being characterized by the steps of:
identifying a start position for writing by reading said pointer areas;
writing data in said data areas beginning from said start position; and

changing the contents of said pointer areas sequentially in accordance with writing data to said data areas.

The invention will now be described by way of example with reference to the accompanying drawings, throughout which like parts are referred to by like references, and in which:

ure 1 is a block diagram of a first embodiment of this invention;

Figure 2 is a flow chart of operation of the first embodiment;

Figures 3 and 4 are tables to explain a pointer areas of the first embodiment;

Figure 5 is a block diagram of a second embodiment of this invention;

Figure 6 is a flow chart of operation of the second embodiment;

Figure 7 is a block diagram of a third embodiment of this invention; and

Figure 8 and 9 are partial block diagrams of the third embodiment of this invention.

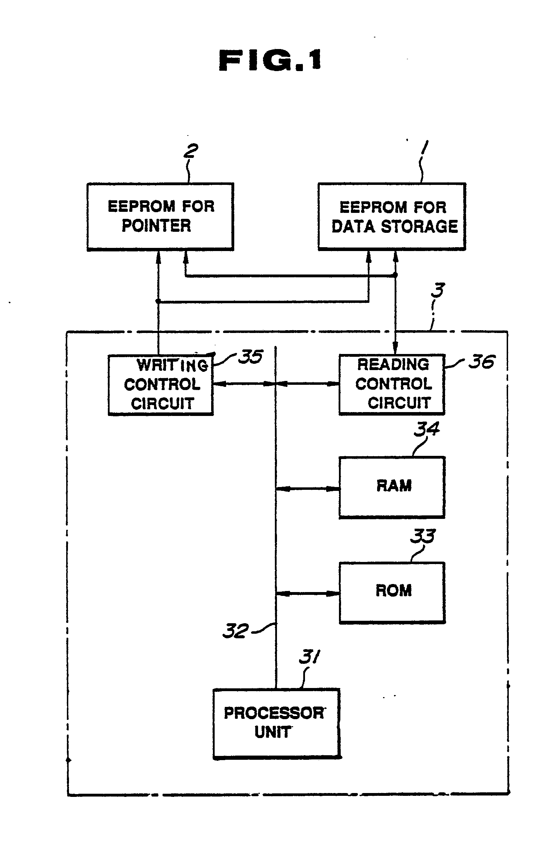

Referring to Figure 1, in the first embodiment it is assumed that one byte of data is written m x n times in an EEPROM in which m re-writings are guaranteed. The embodiment comprises an EEPROM 1 for data storage, an EEPROM 2 for pointer storage, and a controller 3. The EEPROM 2 which has at least n bytes capacity has a pointer area of n bytes to memorize the order of using the data area. The controller 3 comprises a processor unit 31, and a ROM 33, a RAM 34, a writing control circuit 35 and a reading control circuit 36, all connected to a bus 32 of the processor unit 31.

The writing control circuit 35 performs initializing at the time of the first power ON, and writes not only in the data area of the EEPROM 1, but also in the pointer area of the EEPROM 2, corresponding to the data area designated by the processor unit 31, for holding the data stored during a power OFF period. The reading control circuit 36 performs reading from the pointer area and from the data area designated by the processor unit 31. The processor unit 31 causes the pointer area of the EEPROM 2 to store the order of using in the initializing procedure, reads the order of using through the reading control circuit 36, judges the head order of using, and writes data in the data area corresponding to the pointer area through the writing control circuit 35. In this situation, the processor unit 31 replaces the head order in the pointer area with the last order. In utilizing the newest data after turning ON again, the processor unit 31 reads the order of using from the EEPROM 2 through the reading control circuit 36, judges the last position, and reads data from the data area corresponding to the pointer area which holds its last order through the reading control circuit 36. The program for the procedure is stored in the ROM 33. The order or using, or the data read from the EEPROM 1 or the EEPROM 2 are transferred to the RAM 34 and utilized for judging the processing.

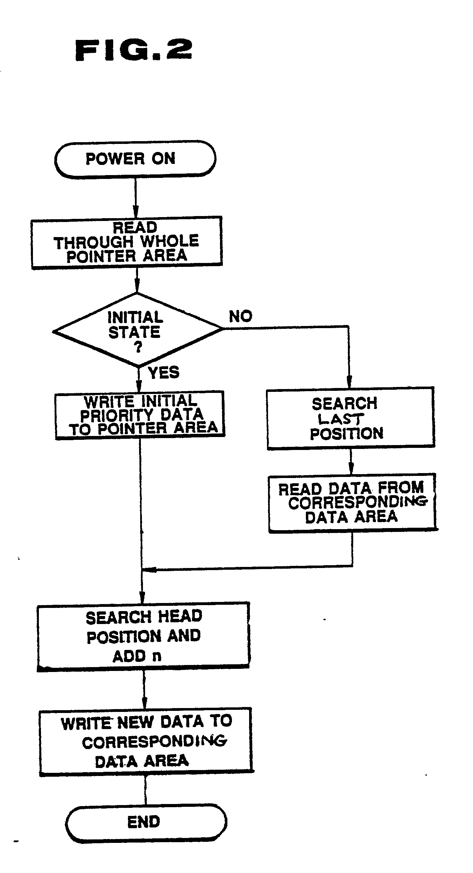

Figure 2 is a flow chart for this embodiment. After the power has been turned ON, the n bytes of data corresponding to the using order are read from the pointer area. If the data (for example, from 0 to n-1) have not been written yet, this is recognized as the initial state of the EEPROM 1, and initial data (for example, from 0 to n-1) are written to each pointer area. This process comprises the initializing process. If the contents of the data storage are full, a last position flag which shows the last position of writing is determined from the pointer data which are read, the data are read from the data storage area corresponding to the pointer data, and these data are used for general process after being transferred to the RAM, 34 for example. This process comprises the reading procedure.

If new data to hold during power OFF appear, a head position flag which shows the first point of writing is searched from the data previously read, and the last position is marked by adding n, for example, to the head position of the pointer area, and the new data are written into the data area corresponding to this pointer area. In this way, n data items are written sequentially into the data area, the newest data being stored in the data area corresponding to the pointer area holding the last position. Thus, the head position (to be written next) can be determined from the last position, which was held during the power OFF period.

The method of distinguishing the data area to be used, by the information of the using order stored in the pointer area is explained below.

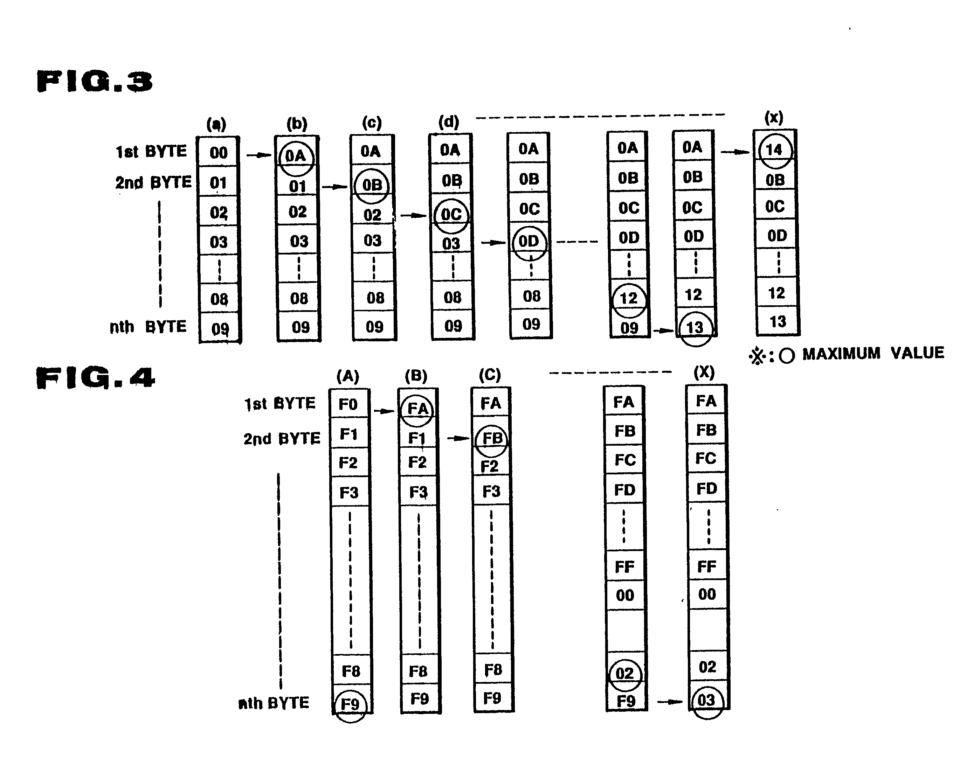

Figures 3 and 4 explain the method of utilizing the pointer area, showing the transition of the position of the pointer area at each writing. In Figure 3, (a) shows an initial state, (b) shows the first written state, and (c) to (x) show further state transitions sequentially achieved by writing data. It is assumed that the number of the data area n equals ten in this explanation.

It is easily judged whether or not the EEPROM 1 is in a pre-initialized state (probably the whole data are FF or OO in hexadecimal notation), by whether the contents of the read pointer EEPROM 2 is sequentially filled with consecutive numbers or not. As shown in Figure 3(a) a series which distinguishes using positions, for example, 00, 01, 02, ..., 09 (equal to n-1) are written from the first byte to the last byte in turn. In Figure 3(a), 00 shows the head position, and 09 shows the last position, and the minimum value shows the head position of the next use. As shown in Figure 3(b), the first data to be re-written next are written on the data area corresponding to the pointer 00, and these pointer data are replaced by OA by adding n (=10) to the number of the pointer to indicate that this pointer area has been used, and to mark it as the last position. Thus, the position number of the data area that has been used always shows the maximum value, which indicates that the newest data are stored in this data area. Writing of data is performed sequentially from the minimum value of the pointer. Therefore, the contents of the EEPROM pointer storage changes in the sequence (b), (c), (d), ... (x) in Figure 3. By adding n to the stored pointer as a marking every time a data area is used, 00 is included in the using order when the result of adding overflows FF (zero cross), as shown in Figure 4(X). On this occasion, the data from F1 to FF are ignored, and the maximum value is regarded as the last position (OO) showing the newest data, while the minimum value in the series F1 ... FF is regarded as the head position for the next re-writing in the pointer area. The area which is next to the last position can also be regarded as the head position. In this embodiment, it is assumed that one data area is formed by one byte, but it can also be formed by a plurality of bytes, or a given number of bits as one word.

Moreover, this invention is not restricted to the use of EEPROMs, but equally applies to other memory devices whose total number of over-writings are limited. Simple decreasing series are also available for the series which shows the using order, in addition to various simple increasing series.

In the first embodiment, the EEPROMs for the data and the pointers are separate, but they can be formed as one EEPROM.

The information storage method and apparatus of the first embodiment of this invention have the following advantages.

1. The limit of using a memory device which has a finite number of re-writing is multiplied n times by establishing n data areas and pointer areas, so the usage of a memory device which has a finite number of re-writings can be increased.

2. Damage to the memory device (for example the EEPROM) is decreased, because no portion of the data area is written continuously.

The second embodiment of this invention is explained hereinafter as applied to an electronic apparatus.

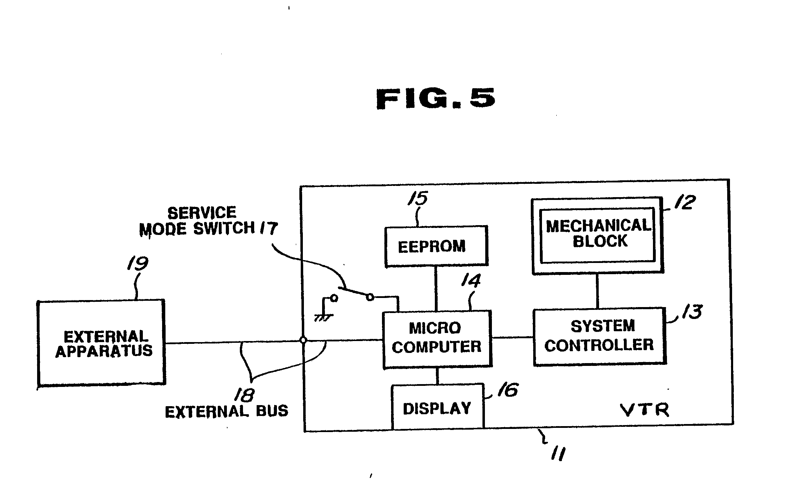

Figure 5 is a block diagram of this embodiment especially for video tape recorder (VTR) apparatus. This apparatus comprises a VTR 11, a mechanical block 12, a system controller 13 for the mechanical block 12, a microcomputer 14 which gives control instructions to the system controller 13 to control the total system, an EEPROM 15 which is accessed by the microcomputer 4 and holds data even during a power OFF period, a display 16 which displays various signs and characters, under the direction of the microcomputer 14, a service mode switch 17 which controls the service mode of the microcomputer 14 during maintenance operations, such as checking or repairing, an external bus 18 of the microcomputer 14, and external apparatus 19 which is connected to the external bus 18 during checking or repairing.

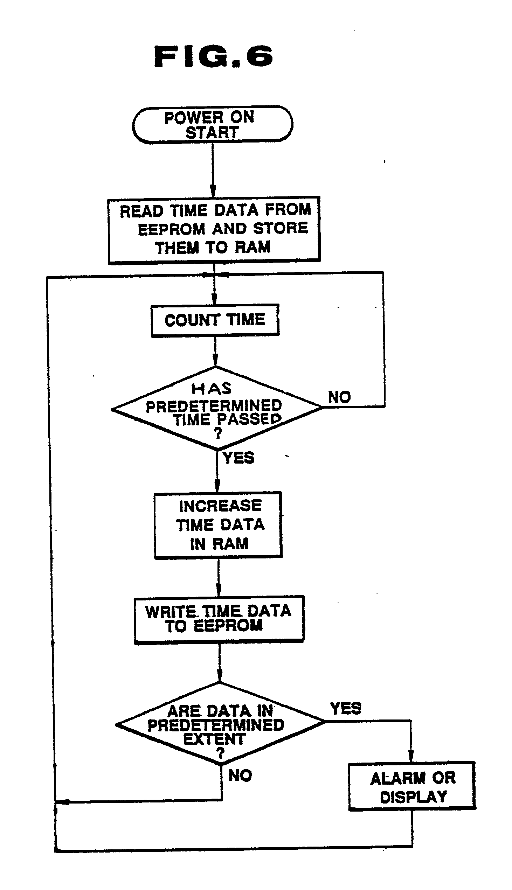

Figure 6 is a flow chart for this embodiment. In this embodiment, time of use data peculiar to each apparatus are written in an EEPROM 5 located in the electronic apparatus (for example the VTR 11), and are read during a service mode.

First, when the microcomputer 14 in Figure 5 starts with the power ON, it reads time data stored in the EEPROM 15 (initial value is zero), and stores it in a RAM within the microcomputer 14. Next, the microcomputer 14 counts up the power-on-time, and increases the value of the time data stored in the RAM every predetermined period (for example, 10 minutes or 1 hour). The nes (increased) data are re-written in the EEPROM 15 every such period. It is possible to write data in the EEPROM 15 within a power-holding time just prior to a power OFF time, to decrease the number of writings. The microcomputer 14 checks whether the time data stored in the RAM are within a predetermined range or outside it, and if this condition is achieved, self-diagnosis can be performed by making an alarm sound or an alarm display. These alarms inform a user of the need for repair or exchange before the apparatus gets out of order.

In repairing, a service person selects a service mode for the microcomputer 14 by turning the service mode switch 17 on. The microcomputer 14 reads written data in the EEPROM 15, and informs the service person of the time data, that is, the accumulated turn-on-time of the VTR 11, by displaying it on the display 16, or reading the data through the external bus 18 to an external apparatus. Alternatively, the microcomputer 14 can get mode information of the VTR 11 from a system controller 13, and then count the total time of operation of a particular mode (for example, the recording or the reproducing mode), and write in the EEPROM 15 at predetermined intervals, to calculate and store the accumulated time of the special mode. These data can be reset to zero during operation in the service mode, by operating switches or receiving an external command from the external bus 18, etc. (that is, zero is written in the EEPROM 15. Thus, the data can be cleared to zero when a head is exchanged at a service centre, and the time of use information for the new head can be monitored.

For the memory device, not only an EEPROM but a battery backed-up RAM and other holdable memory device may also be used. The alarm is optional. The electronic apparatus using the memory device explained in the second embodiment has the following advantages. Because the life of the information storage apparatus is longer than previously employed EEPROMs, this embodiment is able to count accumulated time for a longer time without failure. A measurement of the accumulated working time offers information of timing useful for the exchanging or readjusting or each part in the apparatus. It is therefore necessary that the life of the accumulated working time measurement means is longer than the life of all other parts of the apparatus, so that the accumulated working time measurement is available upon the occurrence of failure of any part.

The third embodiment of this invention, which is applied to a video camera, will now be explained.

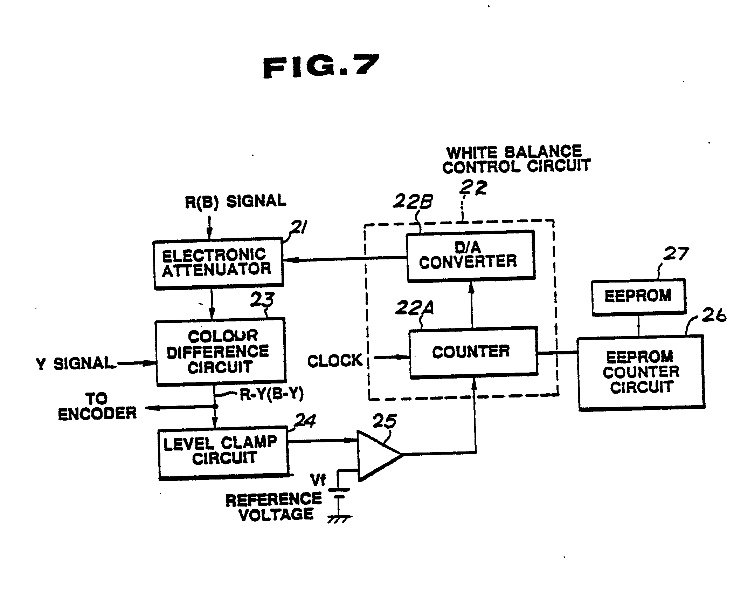

Figure 7 is a block diagram of this embodiment in the white balance system of a video camera. Although Figure 7 shows only a circuit for adjusting the colour balance of the R signal, and memorizing it, there also exists another circuit for adjusting and memorizing the B signal colour balance in a practical unit. As a result, the R and B levels are matched to the G level of the camera. The circuit comprises an electronic attenuator 21 controlled by the output signal of a white balance control circuit 22, which attenuates the R signal; a colour difference circuit 23 which generates a colour difference signal R-Y from the R signal attenuated by the electronic attenuator 21 and the luminance Y signal. The colour difference signal R-Y is supplied to an encoder (not shown), and to a level clamp circuit 24 to make a loop for the white balance control circuit 22. The level clamp circuit 24 fixes a black level of the R signal by fixing the colour difference signal to a predetermined dc level. A comparator 25 compares the output of the level clamp circuit 24 with a reference voltage Vf corresponding to a G signal level, and judges whether the level of the R signal is larger than the G signal level or not. The output of the comparator 25 is connected to the white balance control circuit 22. The white balance control circuit 22 comprises a counter 22A which changes the colour balance and finally memorizes the white balance data, and a digital-to-analogue (D/A) converter 22B which converts the counted value in the counter 22A from digital to analogue form and supplies a control voltage to the electronic attenuator 21. The counter 22A changes the counter value by up-counting or down-counting of a clock signal in accordance with the output of the comparator 25, and stops counting when the output signal of the comparator 25 shows that both input voltages of the comparator 25 have become equal, and memorizes the counted value as the white balance data. An EEPROM control circuit 26 writes the white balance data, which are counted values of two counters 22A for R and B signals, in an EEPROM 27 when white balance is completely adjusted to be equal to the level of the G signal. When the power of the apparatus is turned ON, the EEPROM control cirucit 26 reads the white balance data from the EEPROM 27, and sets the stored data into the counter 22A.

This embodiment makes it possible to extend the life of the information storage means using an EEPROM to several years or several tens of years, by storing white balance data in the memory device as explained in the first embodiment. Thus, even if a video camera has been turned OFF for a long period, when it is turned ON, the last white balance data stored in the EEPROM 27 are set in the counter 22A to revive the last white balance condition.

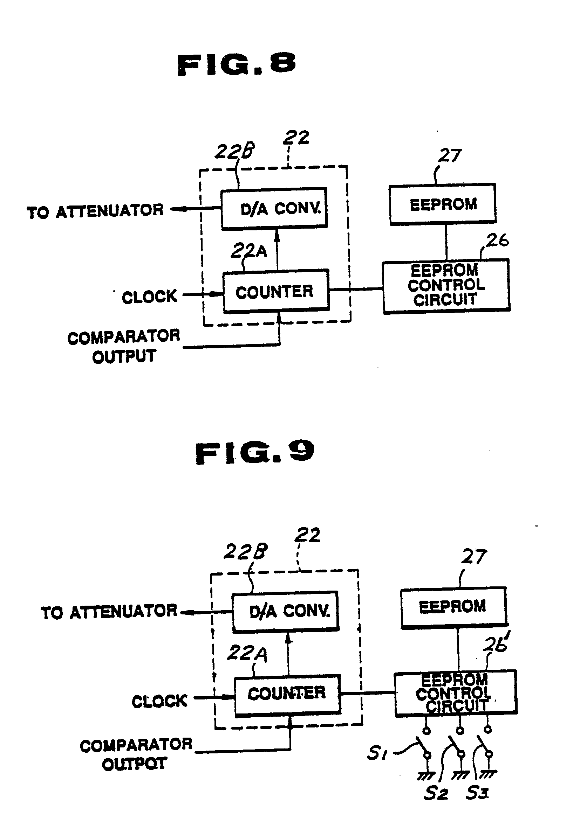

Figure 8 illustrates a part of the embodiment of Figure 7, for a single white balance setting. Figure 9 shows the same part of a block diagram of another embodiment, capable of accommodating a plurality of white balance settings for different light conditions.

The procedure for adjusting the white balance is generally performed by shooting a white subject, so the white balance data are affected by the character of the light source which is used. The embodiment of Figure 9 enables the holding of a plurality of white balance data, and setting the white balance data in accordance with several kinds of light sources. This embodiment comprises basically the same elements as Figure 8, but the EEPROM 27 in Figure 9 has capacity enough to hold a plurality of white balance data sets, and the EEPROM control circuit 26′ has switches S1, S2 and S3 to designate a given set of the data. This construction enables the writing of data in the EEPROM 27 whose addresses are designated by these switches, and the reading of white balance data from the EEPROM 27, whose addresses are designated by these switches. For example, white balance data which are suitable for normal indoor light are stored in the EEPROM 27 by selecting the switch S1, data which are suitable for special studio light are stored by selecting the switch S2, and data which are suitable for outdoor light are stored by selecting the switch S3. These white balance data are read by designating which of the switches S1 to S3 is selected to set the data into the counter 12A, and a suitable white balance is revived in the same manner as in Figure 7. The switches S1 to S3 may be arranged so that only one of them can be selected at a time, and it is possible that white balance data are set from the EEPROM 27 to the counter 22A by selecting one of these switches at the moment of turning on, and the data are reset again by detecting a change of these switches during a power ON period.

In this embodiment, a plurality of white balance data are held during the power OFF period. A suitable memory for this embodiment is not only an EEPROM but also a battery backed-up RAM and other types of memory devices, which can hold data during the power OFF time. As mentioned above, the video camera apparatus using this embodiment writes the white balance into the information storage means, which holds the stored data thus written during the power OFF period. Therefore, it is possible to hold data longer than merely using an ordinary EEPROM. Once the white balance has been adjusted correctly, it is not necessary to adjust it again.

## Claims

1. Apparatus for storing information in a memory device (1) capable of a finite total number of re-writings, the apparatus comprising;
a plurality of data areas in said memory device (1);
characterized by:
a plurality of pointer areas corresponding to said data areas in said memory device (1) to show the order of using said data areas for reading and writing; and
a control means (2, 3) for identifying the start position to re-write, and to change the contents of said pointer areas sequentially in accordance with writing data to said data areas.

2. Apparatus according to claim 1 wherein said contents of said pointer areas are changed in accordance with a simple increasing series, at the time of each writing of data to said data areas.

3. Apparatus according to claim 1 wherein said pointer areas are initialized when the power is turned ON.

4. Apparatus according to claim 2 wherein said memory device (1) is an EEPROM (1).

5. Apparatus according to any one of the preceding claims wherein said data areas and said pointer areas are located in the same memory device (1).

6. Electronic apparatus (1) comprising:
a system (12, 13, 14, 16) for performing various functions of said electronic apparatus (1);
characterized by:
storage means (15) for storing information concerning said apparatus in a memory device (15) capable of a finite total number of re-writings, and further comprising:

a plurality of data areas in said memory device (15);

a plurality of pointer areas corresponding to said data areas in said memory device (15) to show the order of using said data areas for reading and writing; and

a control means for identifying the start position to re-write, and to change the contents of said pointer areas sequentially in accordance with writing data to said data areas.

7. Apparatus (1) according to claim 6, wherein said stored information is accumulated working time.

8. Apparatus (1) according to claim 7 wherein said stored information is accumulated working time in a predetermined mode of said apparatus.

9. Apparatus (1) according to claim 8 wherein said system is a video tape recorder and said predetermined mode is a recording mode or a reproducing mode.

10. Apparatus (1) according to claim 6 wherein said apparatus (1) is a video camera (1) and said stored information is a white balance of said video camera (1).

11. Apparatus (1) according to claim 7 including display means (16) and/or alarm means which is operative when said accumulated time is in a predetermined range or exceeds a predetermined value.

12. A method of storing information written in a memory device (1) having a plurality of data areas and a plurality of pointer areas corresponding to said data areas, said method being characterized by the steps of:

identifying a start position for writing by reading said pointer areas;

writing data in said data areas beginning from said start position; and

changing the contents of said pointer areas sequentially in accordance with writing data to said data areas.

# FIG.1

# FIG.2

```
        ┌─────────────────┐
        │    POWER ON     │
        └────────┬────────┘
                 │
        ┌────────▼────────┐
        │      READ       │
        │ THROUGH WHOLE   │
        │  POINTER AREA   │
        └────────┬────────┘
                 │
            ╱────▼────╲              NO
           ╱  INITIAL  ╲──────────────────────┐
           ╲   STATE   ╱                       │
            ╲    ?    ╱                        │
             ╲──┬──╱                           │
               YES                             │
        ┌────────▼────────┐          ┌─────────▼────────┐
        │ WRITE INITIAL   │          │     SEARCH       │
        │ PRIORITY DATA   │          │      LAST        │
        │ TO POINTER AREA │          │    POSITION      │
        └────────┬────────┘          └─────────┬────────┘
                 │                             │
                 │                   ┌─────────▼────────┐
                 │                   │ READ DATA FROM   │
                 │                   │  CORRESPONDING   │
                 │                   │   DATA AREA      │
                 │                   └─────────┬────────┘
                 │                             │
                 │◄────────────────────────────┘
        ┌────────▼────────┐
        │  SEARCH HEAD    │
        │  POSITION AND   │
        │     ADD n       │
        └────────┬────────┘
                 │
        ┌────────▼────────┐
        │ WRITE NEW DATA TO│
        │  CORRESPONDING  │
        │   DATA AREA     │
        └────────┬────────┘
                 │
        ┌────────▼────────┐
        │      END        │
        └─────────────────┘
```

# FIG.3

※: ◯ MAXIMUM VALUE

# FIG.4

EP 0 340 981 A2

# FIG. 5

SERVICE MODE SWITCH *17*

*19* EXTERNAL APPARATUS

*18* EXTERNAL BUS

*15* EEPROM

*14* MICRO COMPUTER

*16* DISPLAY

*12* MECHANICAL BLOCK

*13* SYSTEM CONTROLLER

VTR

*11*

EP 0 340 981 A2

# FIG.6

```
        ┌──────────────────┐
        │   POWER ON       │
        │   START          │
        └──────────────────┘
                 │
                 ▼
        ┌──────────────────┐
        │ READ TIME DATA FROM │
        │ EEPROM AND STORE  │
        │ THEM TO RAM       │
        └──────────────────┘
                 │
                 ▼
        ┌──────────────────┐
        │   COUNT TIME     │
        └──────────────────┘
                 │
                 ▼
              ╱──────╲
             ╱  HAS   ╲        NO
            ╱ PREDETERMINED ╲ ──────┐
            ╲ TIME PASSED  ╱        │
             ╲    ?    ╱            │
              ╲──────╱             │
                 │ YES             │
                 ▼                 │
        ┌──────────────────┐       │
        │   INCREASE       │       │
        │   TIME DATA      │       │
        │   IN RAM         │       │
        └──────────────────┘       │
                 │                 │
                 ▼                 │
        ┌──────────────────┐       │
        │ WRITE TIME DATA  │       │
        │ TO EEPROM        │       │
        └──────────────────┘       │
                 │                 │
                 ▼                 │
              ╱──────╲             │
             ╱ ARE DATA IN ╲   YES │
            ╱ PREDETERMINED ╲ ─────┤
            ╲   EXTENT     ╱       │
             ╲    ?    ╱          │
              ╲──────╱            │
                 │ NO         ┌────────────┐
                 │            │  ALARM OR  │
                 │            │  DISPLAY   │
                 │            └────────────┘
                 └──────────────────┘
```

# FIG.7

# FIG.8

# FIG.9